# EUROPEAN PATENT APPLICATION

(11) **EP 3 032 741 A1**
(43) Date of publication of application: **15.06.2016**
(21) Application number: 14197413.9
(22) Date of filing: 11.12.2014
(51) Int. Cl.: H03G 3/32, H04S 3/00, H04R 5/04

(54) **Audio signal processing apparatus for a vehicle and signal processing method for a sound system**

(71) Applicant: Alpine Electronics, Inc., Tokyo (JP)
(72) Inventor: Esser, Timo, 70567 Stuttgart (DE)
(74) Representative: Klunker . Schmitt-Nilson . Hirsch

(57) **Abstract**

An audio signal processing apparatus (6) for a vehicle comprises a signal input section (40) through which in operation at least one audio signal (S41-S4n) is provided, a sound reproduction section (50) coupled to the signal input section (40) for reproduction of sound via at least a first loudspeaker channel and a second loudspeaker channel, a signal output section (60) coupled to the sound reproduction section (50) and which is configured to output at least one first output signal (OS1) to at least one first loudspeaker (21-32) of the first loudspeaker channel and at least one second output signal (OS2) to at least one second loudspeaker (21-32) of the second loudspeaker channel, and a sound volume setting section (70) which is configured to control a volume of the at least one first and second output signals (OSI, OS2) and which is configured to receive a control signal (Dv) from at least one detection unit (80), the control signal being variable at different vehicle speeds (v). The sound volume setting section (70) is configured to determine, on the basis of the control signal (Dv) received at a particular vehicle speed (v1), a first volume correction quantity (q1) for the at least one first output signal (OS1), and a second volume correction quantity (q2) for the at least one second output signal (OS2), wherein the second volume correction quantity (q2) is different from the first volume correction quantity (q1), and to control the volume of the at least one first output signal (OS1) depending on the first volume correction quantity (q1) and the volume of the at least one second output signal (OS2) depending on the second volume correction quantity (q2).

## Description

The invention relates to an audio signal processing apparatus for a vehicle comprising a signal input section through which in operation an audio signal is provided and a sound reproduction section coupled to the signal input section for reproduction of sound via at least a first loudspeaker channel and a second loudspeaker channel depending on vehicle speed. The invention further relates to a signal processing method for a sound system in a vehicle.

In known vehicle sound systems, usually the audio sound level and sometimes audio tone (such as bass tone) is automatically adjusted to compensate for vehicle noise originating from engine noise, tyre/road noise, etc. Solutions are known in which this is controlled by vehicle speed input or through a microphone measurement.

Such noise compensation in vehicles is known in the art, wherein typically different measurement and calculation methods are employed.

In US 2006/273855 A1, noise information is acquired by a noise detecting microphone, speed information is acquired by a speed sensor etc, and these items of information are inputted to a microcomputer. The microcomputer reads a program stored in a memory, and calculates a final correction quantity according to an instruction of the program. The microcomputer judges whether to apply a correction quantity based on the noise information or the correction quantity based on the speed information or to increment and decrement these two types of correction quantities. Accordingly, an optimal played-back volume corresponding to a travelling condition can be output.

US 2010/040242 A1 discloses an in-vehicle sound control system structured so that sound sources, a vehicle speed detection unit for detecting a vehicle speed, and an acoustic reproduction apparatus are connected to in-vehicle communications network. The in-vehicle sound control system controls, in accordance with a vehicle speed signal transmitted from the vehicle speed detection unit, a reproduction acoustic signal. The acoustic reproduction apparatus switches, in accordance with a plurality of inputted sound sources and media information of a sound source, a control amount to sound control section determined based on a vehicle speed signal. In this manner, such an in-vehicle sound control system is provided that can provide an optimal automatic sound control for human ears even when the medium is exchanged or when a channel for a sound source in the medium is switched to another channel.

US 5 450 494 A discloses an apparatus for automatically controlling the sound volume of a sound producing apparatus based on ambient noise which includes a microphone which detects the sound produced by the sound producing apparatus and ambient noise. Adaptive filters approximate, based on signals sent from the sound producing apparatus to speakers thereof, the characteristics of the sound components, relating to the sound produced by an individual speaker of the sound producing apparatus, which are received by the microphone. A subtractor subtracts the output of the adaptive filters from the output of the microphone to obtain a signal representing the ambient noise. The adaptive filters receive the signal representing the ambient noise and use this signal as a coefficient updating signal. A signal converter converts the signal representing ambient noise into an ambient noise level representing the volume of ambient noise. A controller then controls the gain by which amplifiers amplify signals sent from the sound producing apparatus to speakers thereof based on the ambient noise level.

It is known that, in existing systems, the volume and tone of an audio signal provided to loudspeakers is adjusted in the system signal path at the point of the user volume control. The amount of compensation is identical for all loudspeaker channels or loudspeaker groups and the level of compensation is usually below the noise level increase to avoid sounding 'too loud', which is known as "under-compensation".

In sound systems with multiple loudspeakers, the speakers can often be grouped into logical channel clusters, like "Main front", "Center", "Surround" "Ambience/3D" "Subwoofer" etc. Sound systems for vehicles are known in the art which provide one or more sound modes, such as stereo sound mode, 3D sound mode, or surround sound mode, involving such multiple loudspeaker channels, such as main speaker channel, center speaker channel, and/or surround speaker channel. Each of these speaker groups or channels typically has a different acoustic playback level, particularly a different sound pressure level (SPL) of output sound. For example, the surround or ambience speaker group is usually operated at a significant lower acoustic output (i.e. lower sound pressure level) than the main front speaker group.

A problem in existing noise compensation technology, with adjusting output levels of all speakers by the same amount, is that due to the psychoacoustic masking effect (also known as auditory masking), lower level speakers become less audible or "disappear" in the vehicle noise from the listeners perspective. Such masking occurs when a sound is made inaudible by a noise or unwanted sound of the same duration as the original sound. Consequently, a desired sound effect like surround sound is then no longer audible to the listener because the surround speakers cannot be head any more. For example, if the noise compensation is tuned perfectly for the front main speakers, the much quieter rear speakers will be drowned out (become inaudible) from the vehicle noise at high speeds.

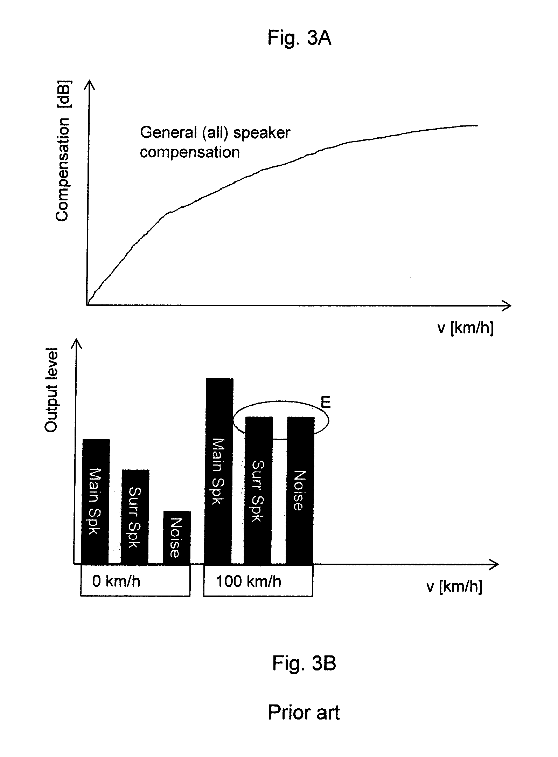

Fig. 3A and 3B show an exemplary noise compensation technique in a vehicle sound system for the speakers of the vehicle as known in the prior art. In Fig. 3A, there is shown an exemplary compensation characteristic depending on variable vehicle speed v, wherein the sound pressure level of sound output from all speakers is compensated according to the shown compensation characteristic. That is, at a particular vehicle speed, due to the increased noise, the sound pressure level of sound output from all speakers is increased by a particular correction quantity in dB according to the shown compensation characteristic depending on vehicle speed.

Usually the output level of all speaker channels is not increased as much as the noise increases at increasing speed (so-called under-compensation, as mentioned above). As a consequence, at high vehicle speeds the lower level speaker channel (such as surround speakers) is masked by the increased vehicle noise. This is shown in Fig. 3B, which shows an exemplary output level for the main speaker channel ("Main Spk") and for the surround speaker channel ("Surr Spk"). For example, at a vehicle speed of 100 km/h, the noise level in the vehicle is approximately the same as the output level of the surround speaker channel (marked by curve E), so that the sound output of the surround speaker channel is masked by the increased vehicle noise, which results in a degraded audio perception experienced by the user.

It is an object of the invention to provide an audio signal processing apparatus for a vehicle and a signal processing method for a sound system in a vehicle which are capable of reducing such degraded audio perception experienced by the user at increasing vehicle speeds.

The invention relates to a signal processing apparatus according to claim 1 and a signal processing method according to claim 15.

According to an aspect, there is disclosed an audio signal processing apparatus for a vehicle, comprising a signal input section through which in operation at least one audio signal is provided, a sound reproduction section coupled to the signal input section for reproduction of sound via at least a first loudspeaker channel and a second loudspeaker channel, a signal output section coupled to the sound reproduction section and which is configured to output at least one first output signal to at least one first loudspeaker of the first loudspeaker channel and at least one second output signal to at least one second loudspeaker of the second loudspeaker channel, and a sound volume setting section which is configured to control a volume of the at least one first and second output signals and which is configured to receive a control signal from at least one detection unit, the control signal being variable at different vehicle speeds. The sound volume setting section is configured to determine, on the basis of the control signal received at a particular vehicle speed, a first volume correction quantity for the at least one first output signal, and a second volume correction quantity for the at least one second output signal, wherein the second volume correction quantity is different from the first volume correction quantity, and to control the volume of the at least one first output signal depending on the first volume correction quantity and the volume of the at least one second output signal depending on the second volume correction quantity.

According to another aspect, there is disclosed a signal processing method for a sound system, the method comprising the steps of reproducing of sound via at least a first loudspeaker channel and a second loudspeaker channel, thereby outputting at least one first output signal to at least one first loudspeaker of the first loudspeaker channel and at least one second output signal to at least one second loudspeaker of the second loudspeaker channel, receiving a control signal from at least one detection unit, the control signal being variable at different vehicle speeds, controlling a volume of the at least one first and second output signals, and determining, on the basis of the control signal received at a particular vehicle speed, a first volume correction quantity for the at least one first output signal to the at least one first loudspeaker, and a second volume correction quantity for the at least one second output signal to the at least one second loudspeaker, wherein the second volume correction quantity is different from the first volume correction quantity, and controlling the volume of the at least one first output signal depending on the first volume correction quantity and the volume of the at least one second output signal depending on the second volume correction quantity.

Thus, according to the invention, there is provided a possibility that acoustically lower loudspeaker channels be compensated (lifted) more at high noise levels in the vehicle than loudspeaker channels which are operated at higher audio levels.

For example, the first and second volume correction quantities are each indicative of a sound pressure level. Thus, the first volume correction quantity may be indicative of a first correction amount of sound pressure level output by the at least one first loudspeaker, and the second volume correction quantity may be indicative of a second correction amount of sound pressure level output by the at least one second loudspeaker.

Preferably, the second volume correction quantity is higher than the first volume correction quantity. In the above embodiment, preferably, the second correction amount of sound pressure level output by the at least one second loudspeaker is higher than the first correction amount of sound pressure level output by the at least one first loudspeaker.

Advantageously, the present invention introduces a separate compensation for each loudspeaker or channel/group/cluster of loudspeakers. This enables a different compensation adjustment for each of these. In practice, this helps to maintain the desired psychoacoustic balance between the speaker groups or channels (e.g. main speaker channel vs. surround speaker channel). For example, the surround effect is then no longer masked by vehicle noise, and any center speaker does not appear to "disappear" any more like in current multi channel sound systems.

According to an embodiment, the sound volume setting section, on the basis of the control signal received at a particular vehicle speed, is configured to add the first volume correction quantity to a volume level of the first output signal and to add the second volume correction quantity to a volume level of the second output signal, wherein the second volume correction quantity is higher than the first volume correction quantity.

According to another aspect, the invention further relates to a vehicle sound system comprising an audio signal processing apparatus according to the invention as described herein, and also to a vehicle including such audio signal processing apparatus according to the invention.

All embodiments as described herein with respect to the apparatus may equally be applied in connection with the method as described herein.

Embodiments of the invention are described in greater detail below with reference to the Figures, in which:
- Fig. 1: shows a perspective schematic view of an exemplary vehicle having an exemplary vehicle sound system in accordance with an embodiment of the invention installed therein,
- Fig. 2: shows a block diagram of an exemplary audio signal processing apparatus in accordance with an embodiment of the invention,
- Fig. 3: shows two diagrams of a compensation applied to output signals provided to loudspeakers of different channels in a vehicle at different vehicle running speeds according to the prior art,
- Fig. 4: shows a diagram of a compensation applied to output signals provided to loudspeakers of different channels in a vehicle at different vehicle running speeds according to an embodiment of the invention.

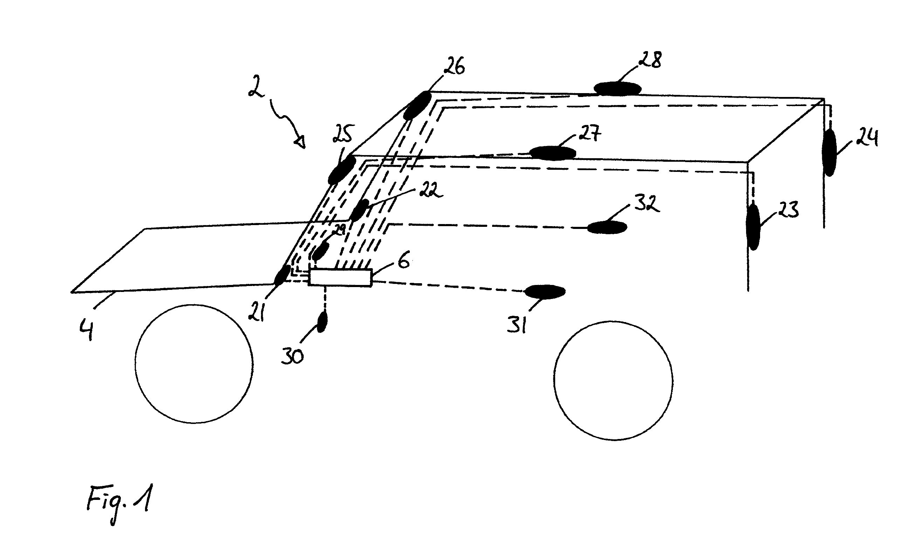

Fig. 1 shows a perspective schematic diagram of a vehicle 4 provided with a vehicle sound system 2 in accordance with an exemplary embodiment of the invention. The vehicle sound system 2 comprises a plurality of (in this example: twelve) loudspeakers 21-32. It should be noted that the invention can be applied with any number of loudspeakers. In particular, the exemplary vehicle sound system 2 comprises a left front speaker 21, a left rear speaker 31, a left surround speaker 23, a right front speaker 22, a right rear speaker 32, a right surround speaker 24, a left front 3D speaker 25, a right front 3D speaker 26, a left rear 3D speaker 27, a right rear 3D speaker 28, a center front speaker 29, and a subwoofer 30. All of these speakers are coupled to an audio signal processing apparatus 6 by individual signal lines (shown in dashed lines in Fig. 1). It is also possible that the speakers 21-32 and the signal processing apparatus 6 are coupled via a bus architecture or any other means of signal communication, e.g. by wire and/or wirelessly.

The vehicle sound system 2 may comprise an audio signal receiving apparatus, such as a tuner, for receiving wireless audio source signals, such as radio broadcast waves or any other kind of signal / data transmission. Additionally or alternatively, it is possible that the vehicle sound system 2 is coupled to an audio source reading apparatus, such as a CD player or a DVD player or a hard disk drive or any other kind of signal / data storage device, e.g. via a data connection such as USB. The audio signal receiving apparatus and/or the audio source reading apparatus may be coupled to the signal processing apparatus 6 for providing the audio source signal(s) to the audio signal processing apparatus 6. No matter what the audio source is, the audio signal processing apparatus 6 is adapted to receive the audio source signal(s) and to generate respective output signals for the plurality of speakers.

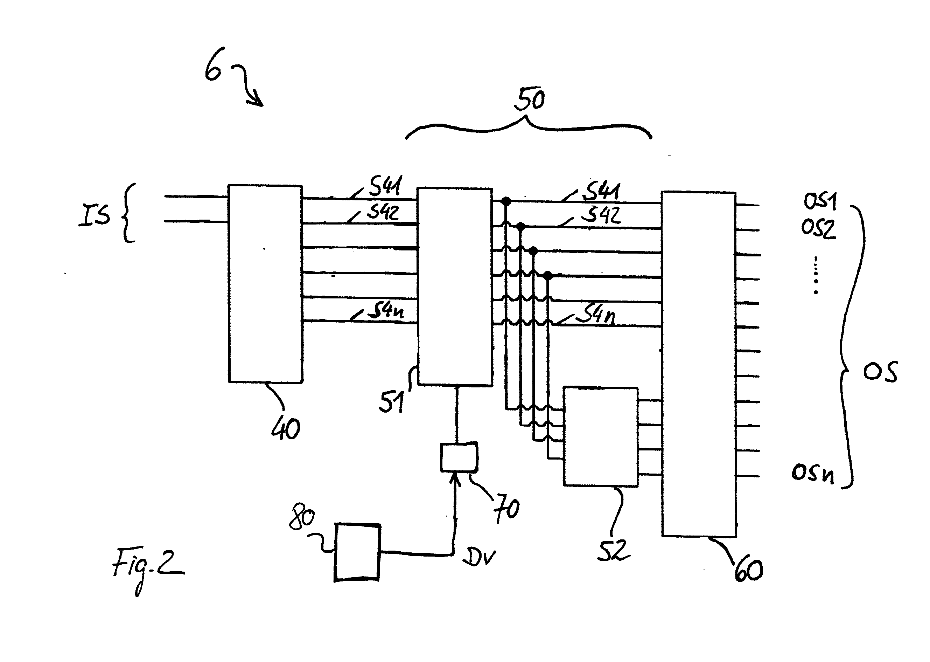

Fig. 2 shows an audio signal processing apparatus 6 in accordance with an exemplary embodiment of the invention. The audio signal processing apparatus 6 comprises a signal input section 40, a sound reproduction section 50, a sound volume setting section 70, and a signal output section 60. The sound reproduction section 50 may comprise, in this embodiment, an audio signal conditioning module 51 and a room simulation module 52, as described further herein below.

The exemplary audio signal processing apparatus 6 of the present embodiment is described with a stereo signal IS as input signal and being the audio source, which may comprise a left source signal and a right source signal, and with a multi-channel output signal OS comprising multiple output signals OS1-Osn for being output to the speakers 21-32 of the vehicle 4 as described above.

The signal input section 40 performs an up-conversion of the two-channel stereo input signal IS. In particular, the signal input section 40 generates audio signals S41 to S4n, e.g. comprising a left front signal, a right front signal, a left surround signal, a right surround signal, a center front signal and a subwoofer signal. Such up-conversion of a two-channel stereo signal into a surround signal via the signal input section 40 is per se known in the art.

The up-converted audio signal is then input into the audio signal conditioning module 51. The audio signal conditioning module 51 is configured to adapt the volume, fading, balance and/or subwoofer levels of the audio signals. Such signal conditioning is also per se known in the art. Depending on the complexity of the vehicle sound system, the audio signal conditioning module 51 may have different functionality and different degrees of signal conditioning. It is also possible that the audio signal conditioning module 51 is dispensed with and that only a simple volume scaling takes place. The only essential aspect is that one or more audio signals (e.g. a multi-channel audio signal) are provided to one or more loudspeakers of a respective loudspeaker channel or group.

For example, in a particular sound mode (such as a 3D or surround sound mode), a loudspeaker optimization distribution mode may be employed by the audio signal conditioning module 51 which is tailored, e.g., to the driver of the vehicle. For example, the front speakers may be supplied differently (e.g. with more emphasis, such as higher volume level) than the rear speakers, i.e. the audio signal conditioning module 51 provides a particular functionality and degree of signal conditioning optimized for the front speakers among the plurality of speakers.

Moreover, according to an embodiment, the signal output section 60 in cooperation with the sound reproduction section 50 outputs a multi-channel output signal OS to the respective speakers. For example, in a stereo mode the signal output section 60 may provide only 8 signals OS1-OS8 to respective 8 speakers, e.g. of a main speaker channel with 4 speakers and a rear speaker channel with 4 speakers. According to another example, the signal output section 60 may provide in a surround sound mode 12 signals OS1-OS12 to respective 12 speakers including, for example, additionally 4 surround speakers according to a surround speaker channel.

Again referring to Fig. 2, the room simulation module 52 is coupled to the audio signal conditioning module 51 in such a way that the left front signal, the left surround signal, the right front signal and the right surround signal are provided to the room simulation module 52. Based on these four signals, the room simulation module 52 generates four 3D signals, which are configured to be output to four speakers, e.g. disposed in the upper portion of the vehicle. For example, the 3D signals are generated in a case in which the 3D sound mode is set as the current preset sound mode in the sound reproduction section 50.

As further shown in Fig. 2, a sound volume setting section 70 is coupled with the sound reproduction section 50 and configured to control a volume of the respective output signal OS1-OSn. Particularly, the sound volume setting section 70 is coupled with the audio signal conditioning module 51. It receives a control signal Dv from at least one detection unit 80.

Generally, as illustrated in an exemplary manner according to the embodiment of Figures 1 and 2, the sound reproduction section 50 reproduces sound via at least a first loudspeaker channel and a second loudspeaker channel. Depending on a sound mode set in the sound reproduction section 50, sound may also be reproduced via an additional loudspeaker channel, such as a subwoofer channel or 3D speaker channel.

Any suitable system configuration other than shown in Figures 1 and 2 may also be used for such purpose and for the embodiments as described herein. Therefore, any embodiments described herein for the present invention shall not be construed as limited to the exemplary system configuration as shown in Figures 1 and 2.

According to an embodiment, the at least one first loudspeaker channel is a main loud-speaker channel (e.g. involving front speakers and/or door speakers) and the at least one second loudspeaker channel is a second loudspeaker channel (such as involving rear speakers) which is different from the main loudspeaker channel.

According to a further embodiment, the at least one first loudspeaker channel is a main loudspeaker channel and the at least one second loudspeaker channel is at least one of the following: a center loudspeaker channel, a subwoofer channel, an ambience loudspeaker channel, a surround loudspeaker channel. That is, the at least one second loudspeaker may be a center loudspeaker, a subwoofer, an ambience loudspeaker, and/or a surround loudspeaker.

For example, the at least one first loudspeaker channel includes a front loudspeaker (such as left front speaker 21 and/or right front speaker 22) and/or a door loudspeaker of the vehicle. That is, the at least one first loudspeaker may be a front loudspeaker and/or a door loudspeaker.

According to an embodiment, the first loudspeaker channel includes multiple first loudspeakers (such as left front speaker 21 and right front speaker 22) and/or the second loudspeaker channel includes multiple second loudspeakers (such as left rear speaker 31 and right rear speaker 32). Further loudspeaker channels can be used, employing e.g. left surround speaker 23, right surround speaker 24 (e.g. of a surround speaker channel), left front 3D speaker 25, right front 3D speaker 26, left rear 3D speaker 27, right rear 3D speaker 28 (e.g. of a 3D speaker channel), center front speaker 29 (e.g. of a center speaker channel), and/or subwoofer 30 (e.g. of a subwoofer channel). At least one, multiple or each of the loudspeaker channels may include only one loudspeaker, or a respective cluster or group of loudspeakers.

By means of the signal output section 60, at least one first output signal (such as OS1) is output to at least one first loudspeaker of the first loudspeaker channel, and at least one second output signal (such as OS2) is output to at least one second loudspeaker of the second loudspeaker channel.

The control signal Dv provided to the audio signal processing apparatus 6 from the detection unit 80 is variable at different vehicle speeds v. That is, with varying vehicle speed, the control signal Dv varies. Particularly, the control signal Dv is indicative of a noise increase in the vehicle at an increasing vehicle speed.

According to an embodiment, the control signal Dv of the detection unit 80 is indicative of a vehicle speed, thus is variable at different vehicle speeds. As noise increases with increasing vehicle speed, the control signal Dv of the detection unit being indicative of a vehicle speed is also indicative of a noise increase in the vehicle at an increasing vehicle speed. For example, the control signal Dv is provided from at least one speed detection unit as commonly used in vehicles, like a car. For example, the detection unit 80 may comprise a vehicle speed sensor used for generating the control signal, which is thus indicative of the current vehicle speed sensed by the vehicle speed sensor.

According to another embodiment, the detection unit 80 may comprise a microphone for measuring noise in the vehicle and used for generating a corresponding control signal Dv. Such measured noise increases at increasing vehicle speed. Accordingly, such control signal Dv is also variable at different vehicle speeds v.

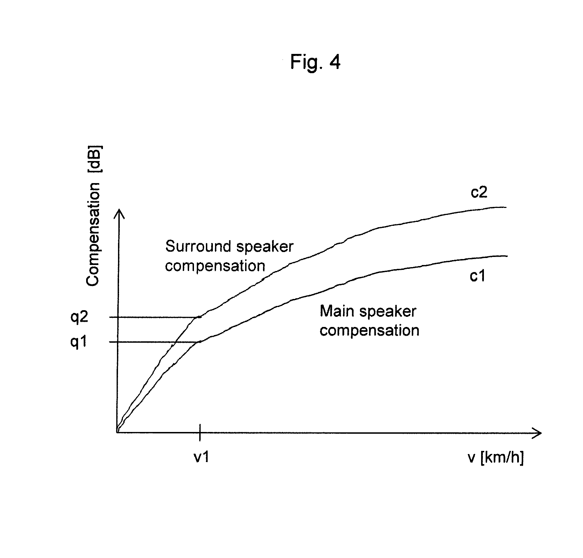

Fig. 4 shows a diagram of a compensation applied to output signals provided to loudspeakers of different channels according to an embodiment of the invention. For example, the vehicle sound system employs a main loudspeaker channel (e.g. including front speakers) and a surround loudspeaker channel (e.g. including surround speakers). In Fig. 4, there are shown two exemplary compensation characteristics which are each depending on vehicle speed v.

For example, with reference to Fig. 4, the sound volume setting section 70 receives a control signal Dv from the detection unit 80 at a particular vehicle speed v1. The sound volume setting section 70 then determines on the basis of the control signal Dv received at the vehicle speed v1 a first volume correction quantity q1 for a first output signal (such as OS1) to a first loudspeaker (e.g. a main speaker, such as a front speaker), or for multiple first output signals to a group of loudspeakers, of a first loudspeaker channel. Further, it determines a second volume correction quantity q2 for a second output signal (such as OS2) to a second loudspeaker (e.g. a surround speaker), or for multiple second output signals to a group of loudspeakers, of a second loudspeaker channel. The sound volume setting section 70 then controls the volume of the first output signal(s) OS1 depending on the first volume correction quantity q1 and the volume of the second output signal(s) OS2 depending on the second volume correction quantity q2.

The second volume correction quantity q2 is different from the first volume correction quantity q1. Preferably, the second volume correction quantity q2 is higher than the first volume correction quantity q1.

For example, the first and second volume correction quantities q1, q2 are each indicative of a sound pressure level. Thus, the first volume correction quantity q1 may be indicative of a first correction amount of sound pressure level output by the at least one first loudspeaker, and the second volume correction quantity q2 may be indicative of a second correction amount of sound pressure level output by the at least one second loudspeaker.

In the above embodiment, preferably, the second correction amount (determined by q2) of sound pressure level output by the at least one second loudspeaker (e.g. a surround speaker) is higher than the first correction amount (determined by q1) of sound pressure level output by the at least one first loudspeaker.

That is, at a particular vehicle speed, due to the increased noise, the sound pressure level of sound output from the speakers is increased by a particular correction quantity q1, q2, respectively, in dB according to the shown compensation characteristics c1, c2 depending on vehicle speed. Both compensation characteristics c1, c2 are at variable vehicle speed v, i.e. depending on vehicle speed v.

In this way, the sound volume setting section 70 determines, on the basis of the control signal Dv received at the vehicle speed v1, the first volume correction quantity q1 according to the first correction characteristic c1, and determines the second volume correction quantity q2 according to the second correction characteristic c2. At increasing vehicle speed the second correction characteristic c2 is steeper than the first correction characteristic c1. That is, a separate compensation for loudspeakers or groups/clusters of loudspeakers of different channels is performed, with one of them compensated more (with steeper increasing volume correction quantities) than the other at increasing vehicle speed. This enables a different compensation adjustment for each of these.

In practice there may be an adjustment curve (such as c1) for the main loudspeakers (e.g. front and rear door speakers) and a sharper or steeper adjustment curve (such as c2) (or compensation factors on top of the curve c1) for other groups of speakers, like the center, subwoofer, ambience and surround loudspeakers.

For example, the audio signal processing apparatus 6 includes a storing means (such as in the sound reproduction section 50) for storing a first table of values of the first correction characteristic c1 at variable vehicle speed v and a second table of values of the second correction characteristic c2 at variable vehicle speed v. Alternatively, there may be stored a first table of values of the first correction characteristic c1 at variable vehicle speed v and a plurality of compensation factors respectively added to respective values of the first correction characteristic c1 forming the second correction characteristic c2 at variable vehicle speed v.

Preferably, the invention applies under-compensation, as mentioned above, wherein the first volume correction quantity q1 is lower than a noise increase of the vehicle 4 at the particular vehicle speed v1 compared to standstill of the vehicle.

According to an embodiment, at a noise increase of approximately 10 dB (or a corresponding vehicle speed increase), which may be determined compared to standstill of the vehicle, the sound volume setting section is configured to set the first volume correction quantity to be approximately between 6 and 8 dB.

According to a further embodiment, at a noise increase of approximately 10 dB (or a corresponding vehicle speed increase), which may be determined compared to standstill of the vehicle, the sound volume setting section is configured to set the second volume correction quantity to be approximately between 7 and 10 dB.

The audio signal processing apparatus, or one or several of its components, such as the signal input section, the sound reproduction section, the sound volume setting section, and/or the signal output section may be implemented in any appropriate manner. They may be implemented in hardware, such as in one or more digital sound processors and/or in digital signal processing components. They may also be implemented (partly) in software in a digital sound processor or in any appropriate combination of hardware and software.

## Claims

1. An audio signal processing apparatus (6) for a vehicle, comprising
- a signal input section (40) through which in operation at least one audio signal (S41-S4n) is provided,
- a sound reproduction section (50) coupled to the signal input section (40) for reproduction of sound via at least a first loudspeaker channel and a second loudspeaker channel,
- a signal output section (60) coupled to the sound reproduction section (50) and which is configured to output at least one first output signal (OS1) to at least one first loudspeaker (21-32) of the first loudspeaker channel and at least one second output signal (OS2) to at least one second loudspeaker (21-32) of the second loudspeaker channel,
- a sound volume setting section (70) which is configured to control a volume of the at least one first and second output signals (OS1, OS2) and which is configured to receive a control signal (Dv) from at least one detection unit (80), the control signal being variable at different vehicle speeds (v),
- wherein the sound volume setting section (70) is configured to determine, on the basis of the control signal (Dv) received at a particular vehicle speed (v1), a first volume correction quantity (q1) for the at least one first output signal (OS1), and a second volume correction quantity (q2) for the at least one second output signal (OS2), wherein the second volume correction quantity (q2) is different from the first volume correction quantity (q1), and to control the volume of the at least one first output signal (OS1) depending on the first volume correction quantity (q1) and the volume of the at least one second output signal (OS2) depending on the second volume correction quantity (q2).

2. The audio signal processing apparatus according to claim 1, wherein the sound volume setting section (70), on the basis of the control signal (Dv) received at a particular vehicle speed (v1), is configured to add the first volume correction quantity (q1) to a volume level of the first output signal (OS1) and to add the second volume correction quantity (q2) to a volume level of the second output signal (OS2), wherein the second volume correction quantity (q2) is higher than the first volume correction quantity (q1).

3. The audio signal processing apparatus according to claim 1 or 2, wherein the at least one first loudspeaker channel is a main loudspeaker channel and the at least one second loudspeaker channel is a second loudspeaker channel different from the main loudspeaker channel.

4. The audio signal processing apparatus according to one of claims 1 to 3, wherein the at least one first loudspeaker channel is a main loudspeaker channel and the at least one second loudspeaker channel is at least one of the following: a center loudspeaker channel (29), a subwoofer channel (30), an ambience loudspeaker channel (27, 28), a surround loudspeaker channel (23, 24).

5. The audio signal processing apparatus according to one of claims 1 to 4, wherein the at least one first loudspeaker channel includes at least one of a front loudspeaker (21, 22) and a door loudspeaker of the vehicle.

6. The audio signal processing apparatus according to one of claims 1 to 4, wherein the at least one first loudspeaker channel includes multiple first loudspeakers (21, 22) and/or the at least one second loudspeaker channel includes multiple second loudspeakers (23-29).

7. The audio signal processing apparatus according to one of claims 1 to 5, wherein the first volume correction quantity (q1) is lower than a noise increase of the vehicle (4) at the particular vehicle speed (v1) compared to standstill of the vehicle.

8. The audio signal processing apparatus according to claim 7, wherein at a noise increase of approximately 10 dB, the sound volume setting section (70) is configured to set the first volume correction quantity (q1) to be approximately between 6 and 8 dB.

9. The audio signal processing apparatus according to claim 7 or 8, wherein at a noise increase of approximately 10 dB, the sound volume setting section (70) is configured to set the second volume correction quantity (q2) to be approximately between 7 and 10 dB.

10. The audio signal processing apparatus according to one of claims 1 to 9, wherein the control signal (Dv) received from the at least one speed detection unit (80) is indicative of a vehicle speed.

11. The audio signal processing apparatus according to one of claims 1 to 10, wherein the sound volume setting section (70) is configured to determine, on the basis of the control signal (Dv) received at a particular vehicle speed (v1), the first volume correction quantity (q1) according to a first correction characteristic (c1) at variable vehicle speed (v), and to determine the second volume correction quantity (q2) according to a second correction characteristic (c2) at variable vehicle speed (v), wherein at increasing vehicle speed the second correction characteristic (c2) is steeper than the first correction characteristic (c1).

12. The audio signal processing apparatus according to claim 11, further including a storing means (50) for storing a first table of values of the first correction characteristic (c1) at variable vehicle speed (v) and a second table of values of the second correction characteristic (c2) at variable vehicle speed (v).

13. The audio signal processing apparatus according to claim 11, further including a storing means (50) for storing a first table of values of the first correction characteristic (c1) at variable vehicle speed (v) and a plurality of compensation factors respectively added to respective values of the first correction characteristic (c1) forming the second correction characteristic (c2) at variable vehicle speed (v).

14. Vehicle sound system (2) comprising an audio signal processing apparatus (6) according to any of the preceding claims.

15. A signal processing method for a sound system (2) in a vehicle, the method comprising the steps of:
- reproducing of sound via at least a first loudspeaker channel and a second loudspeaker channel, thereby outputting at least one first output signal (OS1) to at least one first loudspeaker (21-32) of the first loudspeaker channel and at least one second output signal (OS2) to at least one second loudspeaker (21-32) of the second loudspeaker channel,
- receiving a control signal (Dv) from at least one detection unit (80), the control signal being variable at different vehicle speeds (v),
- controlling a volume of the at least one first and second output signals (OS1, OS2),
- determining, on the basis of the control signal (Dv) received at a particular vehicle speed (v1), a first volume correction quantity (q1) for the at least one first output signal (OS1) to the at least one first loudspeaker, and a second volume correction quantity (q2) for the at least one second output signal (OS2) to the at least one second loudspeaker, wherein the second volume correction quantity (q2) is different from the first volume correction quantity (q1), and controlling the volume of the at least one first output signal (OS1) depending on the first volume correction quantity (q1) and the volume of the at least one second output signal (OS2) depending on the second volume correction quantity (q2).
